# FASCICULE DE BREVET EUROPEEN

(11) **EP 0 923 123 B1**
(45) Date de publication et mention de la délivrance du brevet: **09.01.2008**
(21) Numéro de dépôt: 98402973.6
(22) Date de dépôt: 27.11.1998
(51) Int. Cl.: H01L 25/075, G02F 1/136

(54) **Procédé de transfert selectif d'une microstructure, formée sur un substrat initial, vers uns substrat final.**
Selektiver Transferprozess einer Mikrostruktur, geformt auf Initialsubstrat, auf ein Finalsubstrat
Process of selective transfer of a microstructure, formed on an initial substrate, to a final substrate

(30) Priorité: 02.12.1997 FR 9715152
(43) Date de publication de la demande: 16.06.1999
(73) Titulaire: COMMISSARIAT A L'ENERGIE ATOMIQUE, 75015 Paris (FR)
(72) Inventeur: Joly, Jean-Pierre, 38120 Saint-Egreve (FR); Nicolas, Gérard, 38340 Voreppe (FR); Bruel, Michel, 38113 Veurey (FR)
(74) Mandataire: Poulin, Gérard

(56) Documents cités:
- US-A- 5 258 325
- US-A- 5 508 065

## Description

### Domaine technique

La présente invention concerne un procédé de transfert sélectif d'une microstructure formée sur un substrat, dit substrat initial, vers un substrat, dit substrat final.

Au sens de la présente invention, on entend par microstructure tout composant, ou ensemble de composants, électroniques, mécaniques ou optiques, formé sur le substrat initial, par des techniques d'usinage, de dépôt de matériau et de mise en forme de matériau propres à la micro-électronique ou à la micromécanique.

En particulier, l'invention permet le transfert de composants électroniques qui peuvent être des composants passifs ou des composants actifs tels que des puces.

Le transfert de composants conforme à l'invention est particulièrement avantageux dans des applications où différents composants d'un dispositif doivent être réalisés sur des substrats en matériaux différents, et dans les applications pour lesquelles on souhaite fabriquer séparément un certain nombre de composants d'un dispositif avant son assemblage.

A titre d'exemple, l'invention peut être mise en oeuvre pour le report de cavités laser, réalisées séparément, sur un substrat de silicium.

Dans un autre domaine, l'invention peut s'appliquer aussi au report de composants de circuits de commande d'un écran d'affichage à cristaux liquides, sur une plaque de verre destinée à la fabrication d'un afficheur.

### Etat de la technique antérieure

Les techniques connues, pour le transfert d'un composant d'un substrat initial vers un substrat final, mettent en oeuvre en général un substrat dit intermédiaire dont la fonction essentielle est le maintien mécanique du composant lors du transfert.

Les principaux problèmes rencontrés lors de la mise en oeuvre des transferts de composants sont liés à la séparation du composant d'avec le substrat initial, mais aussi à la séparation du composant d'avec le substrat intermédiaire.

Généralement, la séparation des composants d'avec les supports initial ou intermédiaire, a lieu selon une technique dite de pelage ("lift-off"). Pour mettre en oeuvre cette technique, on utilise des substrats qui comportent une partie massive de base, une couche intermédiaire sacrificielle mince en un matériau pouvant être gravé sélectivement par voie chimique, et une couche supérieure dans laquelle sont formés les composants ou sur laquelle sont reportés les composants.

Lors d'un transfert des composants, la séparation de la couche superficielle comprenant les composants d'avec la partie massive de base dépourvue de composants a lieu en attaquant chimiquement la couche intermédiaire sacrificielle pour l'éliminer. L'élimination de cette couche permet de libérer les composants de la couche superficielle par un effet de pelage.

Cette technique présente un certain nombre de difficultés et de limitations.

Une première difficulté est liée à la mise en contact de la couche intermédiaire avec un agent chimique de gravure, généralement liquide. En effet, comme la couche intermédiaire est mince et qu'elle est située entre la partie de base et la couche superficielle, l'action de l'agent chimique n'est pas très efficace. Cette difficulté augmente avec la taille du composant à transférer, c'est-à-dire avec l'étendue de la couche intermédiaire sacrificielle.

Par ailleurs, la nécessité de réaliser une gravure sélective de la couche intermédiaire, sans altérer le composant devant être transféré, conduit à l'utilisation de matériaux particuliers dont la mise en oeuvre n'est pas toujours compatible avec les exigences d'une production en série.

A titre d'illustration de l'état de la technique, on peut se reporter aux documents (1) et (2) dont les références sont indiquées à la fin de la présente description.

### Exposé de l'invention

La présente invention a pour but de proposer un procédé de transfert d'une microstructure d'un substrat initial vers un substrat final ne présentant pas les difficultés et limitations évoquées ci-dessus.

Un but est en particulier de proposer un tel procédé ne nécessitant pas la gravure d'une couche intermédiaire sacrificielle ni d'opération de pelage.

Un autre but de l'invention est de proposer un procédé permettant le transfert sélectif d'une ou plusieurs régions d'un substrat comprenant des microstructures données, vers des zones particulières d'un substrat final.

Un but est également de proposer un procédé de transfert, rapide, peu coûteux et susceptible d'être mis en oeuvre de façon industrielle dans le cadre d'une production en série.

Pour atteindre ces buts, l'invention a plus précisément pour objet un procédé de transfert d'au moins une microstructure formée sur un substrat, dit substrat initial, vers un substrat, dit substrat final. Le procédé comprend les étapes successives suivantes :
a) préparation du substrat initial pour autoriser une solidarisation réversible, avec une force de liaison initiale, du substrat initial avec un substrat dit intermédiaire,
b) solidarisation du substrat initial avec le substrat intermédiaire, la microstructure étant tournée vers le substrat intermédiaire,
c) formation d'une couche de matériau de liaison, sur au moins une région sélectionnée du substrat initial, comprenant la microstructure et/ou sur une région de réception du substrat final, le matériau de liaison présentant une capacité de liaison qui peut être augmentée par un traitement approprié,
d) mise en contact de ladite région sélectionnée du substrat initial avec la région de réception du substrat final,
e) traitement de la couche de matériau de liaison dans une zone correspondant à la région du substrat initial comprenant la microstructure pour augmenter, dans cette zone, la force de liaison à une valeur supérieure à la force de liaison initiale, pour obtenir une fixation de ladite région du substrat initial sur la région de réception du substrat final,
f) désolidarisation de la région du substrat initial comprenant la microstructure d'avec le substrat intermédiaire.

Comme indiqué précédemment, la microstructure formée dans le substrat peut être constituée d'un ou de plusieurs composants électroniques, optiques ou mécaniques.

Cette structure peut être formée à la surface du substrat par dépôt et par mise en forme de matière sur la surface du substrat. Elle peut également être formée dans l'épaisseur du substrat, sous la forme de régions dopées et de composants enterrés. La structure peut aussi consister en une combinaison de composants formés en profondeur dans le substrat et de composants, tels que des prises de contact, formés à sa surface.

Il apparaît que le procédé de l'invention ne comporte pas d'opération de pelage nécessitant l'attaque chimique d'une couche sacrificielle enterrée.

De plus, grâce à l'invention, et notamment l'étape e) de traitement sélectif dans une ou plusieurs régions du substrat, il est possible de réaliser des transferts sélectifs ne concernant que ces régions.

En effet, l'action combinée de la préparation du substrat initial, pour rendre réversible sa solidarisation avec le substrat intermédiaire, et le renforcement local des liaisons entre la structure à transférer et le substrat final, permet de désolidariser sélectivement cette structure.

La désolidarisation peut être réalisée notamment par arrachement de la région du substrat initial comprenant la microstructure, du substrat intermédiaire.

Selon un aspect particulier de l'invention la préparation de la surface du substrat initial, pour autoriser une solidarisation réversible, peut comporter la formation d'une rugosité contrôlée à ladite surface du substrat.

La rugosité permet de réduire la surface de contact entre le substrat initial et le substrat intermédiaire.

Ainsi, la solidarisation effectuée, par exemple, par collage, avec apport de matière ou non, entraîne des forces de liaison relativement faibles qui peuvent être vaincues lors de l'arrachement de la microstructure.

En particulier, la rugosité est choisie telle que la force de liaison initiale entre le substrat initial et le substrat intermédiaire soit inférieure à la force de liaison entre la région sélectionnée du substrat initial et le substrat final, après le traitement de l'étape e).

Selon une variante, la préparation de la surface du substrat initial, pour autoriser une solidarisation réversible, peut aussi comporter la formation dans le substrat initial d'au moins une amorce de rupture.

L'amorce de rupture peut être formée en particulier par l'implantation ionique, par exemple d'hydrogène, dans une partie du substrat initial destinée à être solidarisée avec le substrat intermédiaire. Les ions d'hydrogène implantés dans le substrat initial créent une zone de fragilité selon laquelle la désolidarisation de la région sélectionnée du substrat initial, comprenant la microstructure, peut avoir lieu.

Dans ce cas, la force de liaison initiale est comprise comme étant la force de liaison qu'il est nécessaire de vaincre pour provoquer la désolidarisation par arrachage selon la zone de fragilité.

Selon une autre variante encore, la préparation de la surface du substrat initial, pour autoriser une solidarisation réversible, peut comporter la formation à la surface du substrat d'une couche, dite couche de rupture, la couche de rupture présentant une première épaisseur dans une zone située en face d'au moins une région du substrat initial, comportant une microstructure, et présentant une deuxième épaisseur, supérieure à la première épaisseur, dans une zone située en face d'une région du substrat initial dépourvue de microstructure.

La formation de la couche de rupture peut comporter le dépôt, sur la surface du substrat, d'une couche d'un matériau pouvant être sélectivement gravée par rapport au substrat. Cette couche est alors soumise à gravure partielle sélective pour l'amincir dans au moins une zone correspondant à au moins une région du substrat qui comporte une microstructure. Cette gravure ne présente pas de difficulté particulière car la couche de matériau à graver est librement accessible à la surface du substrat initial.

Cette mise en oeuvre particulière de l'invention est décrite avec plus de détails dans la suite de la description.

Selon un autre aspect particulier de l'invention, on peut effectuer un amincissement du substrat initial préalablement à l'étape c).

L'amincissement peut être effectué par gravure chimique ou mécanique.

Il peut aussi être effectué par clivage selon une couche de clivage préalablement implantée dans le substrat initial.

Selon un autre aspect avantageux de l'invention, il est possible de former, en outre, avant l'étape d), au moins une tranchée de fragilisation du substrat initial entourant ladite région du substrat comprenant la microstructure. De préférence, les tranchées de fragilisation et la zone de la couche de rupture présentant la première épaisseur sont agencées de façon à coïncider, au moins en partie.

Grâce aux tranchées, il est possible de désolidariser avec plus de facilité la région du substrat initial comprenant la microstructure d'avec le substrat intermédiaire. Il est de plus possible de désolidariser plus facilement cette région du substrat, de la partie restante du substrat initial qui n'est pas concernée par le transfert et qui reste solidaire du substrat intermédiaire.

Le traitement de la couche de matériau de liaison, lors de l'étape e) du procédé, peut comporter l'application d'un rayonnement dans la région du substrat comprenant la microstructure.

Selon le matériau de liaison choisi, le rayonnement peut être adapté pour provoquer une réticulation ou une fusion du matériau de liaison et conduire ainsi, éventuellement après un temps de refroidissement, à liaison plus forte. Cet aspect est décrit avec plus de détails dans la suite du texte.

Selon un aspect particulier de mise en oeuvre de l'invention, on peut utiliser un substrat intermédiaire transparent et appliquer le rayonnement à la région du substrat comprenant la microstructure, et la couche de matériau de liaison, à travers le substrat transparent.

On peut également utiliser un substrat final transparent et appliquer le rayonnement à la région du substrat comprenant la microstructure, et la couche de matériau de liaison, à travers le substrat final.

Le procédé de l'invention est adapté en particulier pour le transfert de structures d'une épaisseur inférieure à 10 µm, mais dont l'aire dans le plan de la surface du substrat initial peut aller de quelques µm² à quelques cm².

Selon l'aire de la structure, le rayonnement appliqué pour le traitement du matériau de liaison, peut être appliqué de façon ponctuelle ou par balayage.

De façon avantageuse, en particulier lorsque l'un des substrats intermédiaire ou final est transparent, on peut former respectivement sur le substrat final et intermédiaire des repères visuels qui permettent un alignement précis des substrats lors de l'étape d) du procédé.

Un telle mesure permet en particulier de prévoir un assemblage automatique des substrats par une machine appropriée.

D'autres caractéristiques et avantages de l'invention ressortiront de la description qui va suivre, en référence aux figures des dessins annexées. Cette description est donnée à titre purement illustratif et non limitatif.

### Brève description des figures

- La figure 1 est une coupe schématique d'un substrat initial, équipé d'une microstructure et solidarisé avec un substrat intermédiaire.
- La figure 2 est une coupe schématique du substrat de la figure 1 préparé pour une solidarisation avec un substrat final.
- La figure 3 est une coupe schématique du substrat de la figure 2 lors de la solidarisation d'une région sélectionnée de ce substrat avec le substrat final.
- La figure 4 est une coupe schématique illustrant la désolidarisation de la région sélectionnée d'avec le substrat intermédiaire.
- La figure 5 est une coupe schématique illustrant la région sélectionnée, solidaire du substrat final, et la réalisation d'une prise de contact avec la microstructure située dans ladite région sélectionnée.

### Description détaillée de modes de mise en oeuvre de l'invention

La description qui suit concerne le transfert particulier d'une seule microstructure. Toutefois, on comprendra que le procédé de transfert peut avoir lieu simultanément pour plusieurs de telles microstructures.

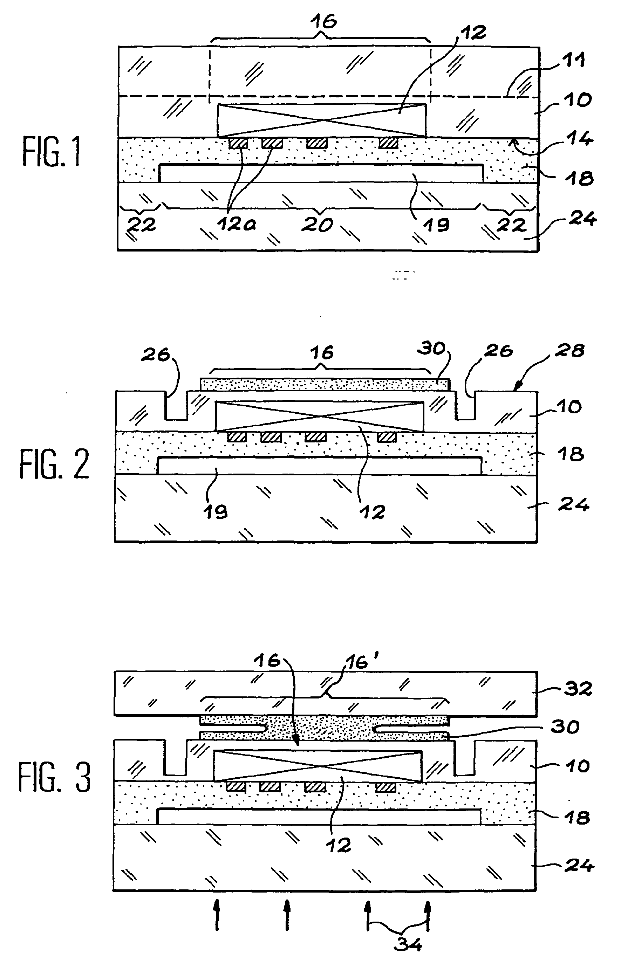

La figure 1 montre un substrat initial 10, par exemple en silicium, dans lequel est formée une microstructure. Dans l'exemple décrit, la microstructure comporte un circuit électronique 12 formé en profondeur dans le substrat 10 et des prises de contact 12a formées à la surface 14 dudit substrat. La région du substrat comprenant la microstructure est indiquée par la référence 16. Cette région est appelée région de transfert dans la suite du texte.

Sur la surface 14 du substrat est formée une couche 18, dite couche de rupture. Il s'agit par exemple d'une couche de silice ou de polymère. L'épaisseur de cette couche est choisie suffisante pour pouvoir y pratiquer une dépression 19 en face de la région de transfert 16 du substrat. La dépression est réalisée par gravure locale de la couche de rupture 18 et permet de définir dans cette couche deux zones. Une zone amincie, avec une première épaisseur, située essentiellement en face de la région de transfert 16 et une zone 22 avec une deuxième épaisseur, plus importante en dehors de la région de transfert. On peut noter que la zone amincie peut d'étendre de préférence légèrement au-delà de l'étendue de la région de transfert.

Le substrat initial 10 est solidarisé avec un substrat intermédiaire 24 au moyen de la couche de rupture 18 dont la zone 22, plus épaisse, est scellée sur le substrat intermédiaire 24.

En raison de la dépression 19, la force de liaison initiale entre premier substrat et le substrat intermédiaire est faible.

A cet effet, il convient de réaliser, de préférence, une dépression 19 avec une profondeur suffisante pour que, compte tenu du profil de contraintes des matériaux utilisés, la couche de rupture 18 ne se courbe pas vers le substrat intermédiaire et ne vienne pas se coller contre celui-ci dans la région de la dépression 19.

La figure 2 illustre une étape ultérieure du procédé lors de laquelle le substrat initial 10 est aminci. L'amincissement est arrêté de façon à laisser subsister une épaisseur du substrat suffisante pour contenir et garantir le maintien mécanique du composant 12.

L'amincissement peut avoir lieu par rodage, par rectification, par attaque chimique, avec ou sans couche d'arrêt, ou encore par clivage.

Dans le cas d'un amincissement par clivage, une couche d'ions gazeux, dite couche de clivage, représentée de façon schématique avec la référence 11 sur la figure 1, est implantée préalablement dans le substrat initial. Ainsi, un traitement thermique permet, par un effet de réarrangement cristallin, de provoquer le clivage du substrat selon cette couche.

En plus de l'amincissement, des tranchées 26 sont pratiquées (par gravure) dans le substrat initial 10 à partir de sa surface libre 28 obtenue après l'amincissement.

Les tranchées 26, qui s'étendent sur tout ou partie de l'épaisseur du substrat initial restant, permettent de délimiter dans ce substrat la région 16 comportant le composant électronique 12 qui doit être transféré. Elles coïncident, au moins en partie, avec la dépression 19 pratiquée dans la couche de rupture 18.

En particulier, les tranchées constituent une zone de plus faible résistance du substrat initial.

Comme le montre la figure 2, une couche 30 de matériau de liaison est formée localement sur la surface libre 28 du substrat initial essentiellement dans la région de transfert 16.

Le matériau de liaison est un matériau dont la capacité de liaison peut être augmentée par un traitement approprié.

Il s'agit par exemple, d'un polymère durcissable avec un rayonnement U.V.

Dans l'exemple décrit, le matériau de liaison est un matériau fusible tel que Sn, Pb, Sn-Pb, In-Pb etc. Lorsque un tel matériau est chauffé par un rayonnement approprié, il fond, et permet, après refroidissement, d'obtenir une liaison très forte.

Selon une possibilité avantageuse de mise en oeuvre de l'invention, le matériau de liaison peut être choisi électriquement conducteur pour réaliser des connexions électriques entre le composant 12 de la région de transfert 16 et des composants du substrat final. Dans un tel cas le matériau de liaison peut être formé par un alliage conducteur fusible tel que mentionné ci-dessus ou par une colle conductrice.

Le matériau de liaison peut être formé sur toute la surface de la région de transfert ou seulement sur des parties sélectionnées, afin de former une ou plusieurs connexions électriques indépendantes avec le substrat final.

On peut noter que la couche de matériau de liaison peut aussi être formée sur tout ou partie d'une région de réception du substrat final.

La figure 3 montre une étape ultérieure lors de laquelle une région de réception 16' d'un substrat final 32 est mis en contact avec la région de transfert 16 du substrat initial (comportant le composant 12).

On observe sur cette figure qu'à la fois la région de transfert 16 et la région de réception 16' sont munies d'une couche de matériau de liaison 30.

Un rayonnement 34, tel qu'un rayonnement infrarouge, est appliqué à la région de transfert par l'intermédiaire du substrat intermédiaire 24 qui est choisi transparent à ce rayonnement. Le rayonnement 34 permet de faire fondre le matériau de liaison fusible de la couche 30 et permet de souder la région de transfert 16 sur le substrat final 32. La force de liaison maximum est obtenue après refroidissement de la région de transfert et du matériau fusible.

Dans une variante où le matériau de liaison est un polymère photodurcissable par un rayonnement ultraviolet, il convient d'utiliser des substrats intermédiaires transparents à un tel rayonnement.

On peut noter que l'application du rayonnement au matériau de liaison peut aussi avoir lieu par l'intermédiaire du substrat final 32 qui est choisi transparent ou non selon le type de matériau de liaison utilisé.

Après la fixation ferme de la région de transfert 16 comprenant le composant 12, sur le substrat final 32, la séparation de cette région d'avec le substrat intermédiaire peut avoir lieu.

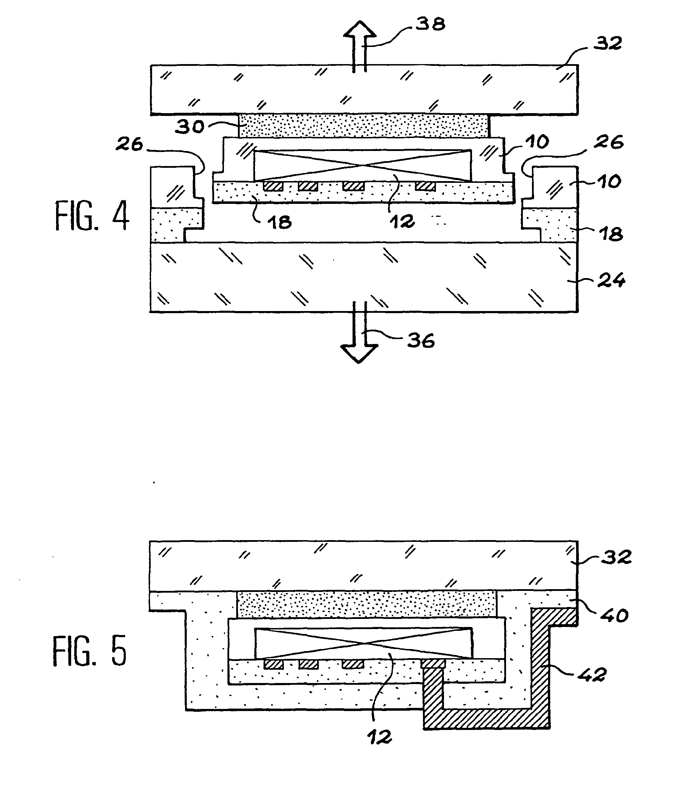

Cette séparation est représentée à la figure 4. Des forces de traction 36, 38 et éventuellement de cisaillement, sont appliquées sur le substrat final 32 et sur le substrat intermédiaire.

Comme la force de liaison de la couche de matériau de liaison 30 a été augmentée dans la région de transfert 16, cette région reste fixée sur le substrat final.

Par contre, un arrachement du substrat initial se produit au fond des tranchées 26.

Ainsi la région 16 du substrat initial, comportant le composant 12, est libérée, non seulement du substrat intermédiaire, mais aussi du restant du substrat initial 10, ne comprenant pas le composant.

La figure 5 illustre des étapes de traitement qui suivent le transfert de la microstructure.

Une couche isolante 40 est déposée sur la microstructure et sur le substrat final. Puis, des pistes de connexion métallique, telles que la ligne 42, représentée sur la figure 5, sont formées pour relier électriquement les prises de contact 12a du composant 12 à d'autres composants, non représentés, du substrat cible.

Ainsi le composant 12 peut être connecté électriquement à des composants du substrat final 32 par des pistes conductrices et/ou par l'intermédiaire du matériau de liaison 30, comme évoqué précédemment.

### DOCUMENTS CITES

***(1)***
   US-A-5 258 325
***(2)***
   "Alignable Epitaxial Liftoff of GaAs Materials with Selective Deposition Using Polyimide Diaphragms" de C. Camperi-Ginestet et al. IEEE transactions Photonics Technology Letters, vol. 3, n°12. December 1991, pages 1123-1126.

## Revendications

1. Procédé de transfert d'au moins une microstructure (12) formée sur un substrat (10), dit substrat initial, vers un substrat (32) dit substrat final, le procédé comprenant les étapes successives suivantes :
a) préparation du substrat initial pour autoriser une solidarisation réversible, avec une force de liaison initiale, du substrat initial (10) avec un substrat (24) dit intermédiaire,
b) solidarisation du substrat initial (10) avec le substrat intermédiaire (24), la microstructure étant tournée vers le substrat intermédiaire,
c) formation d'au moins une couche de matériau de liaison (30) sur au moins une région sélectionnée (16) du substrat initial, comprenant la microstructure, et/ou sur une région de réception (16') du substrat final, le matériau de liaison présentant une capacité de liaison qui peut être augmentée par un traitement approprié,
d) mise en contact de ladite région sélectionnée (16) du substrat initial avec la région de réception du substrat final,
e) traitement de la couche de matériau de liaison dans une zone correspondant à la région sélectionnée (16) du substrat initial, comprenant la microstructure, pour augmenter, dans cette zone, la force de liaison à une valeur supérieure à la force de liaison initiale, pour obtenir une fixation de ladite région sélectionnée (16) du substrat initial sur la région de réception (16') du substrat final (32),
f) désolidarisation de la région sélectionnée (16) du substrat initial, comprenant la microstructure, d'avec le substrat intermédiaire (24).

2. Procédé de transfert selon la revendication 1, dans lequel on effectue un amincissement du substrat initial (10) préalablement à l'étape c).

3. Procédé de transfert selon la revendication 2, dans lequel l'amincissement du substrat initial (10) est effectué par une gravure chimique et/ou mécanique.

4. Procédé de transfert selon la revendication 2, dans lequel l'amincissement du substrat initial (10) est effectué par clivage selon une couche de clivage (11) préalablement implantée dans le substrat initial (10).

5. Procédé de transfert selon la revendication 1, dans lequel la préparation du substrat initial, pour autoriser une solidarisation réversible, comporte la formation d'une rugosité contrôlée à la surface du substrat (10).

6. Procédé de transfert selon la revendication 1, dans lequel la préparation du substrat initial, pour autoriser une solidarisation réversible, comporte la formation, dans le substrat initial, d'au moins une amorce de rupture.

7. Procédé de transfert selon la revendication 1, dans lequel la préparation du substrat initial, pour autoriser une solidarisation réversible, comporte la formation à la surface (14) du substrat (10) d'une couche (18) dite couche de rupture, la couche de rupture présentant une première épaisseur dans une zone située en face de la région sélectionnée (16) du substrat initial, comportant une microstructure (12), et présentant une deuxième épaisseur supérieure à la première épaisseur dans une zone située autour de la région sélectionnée (16).

8. Procédé de transfert selon la revendication 7, dans lequel la formation de la couche de rupture (18) comporte le dépôt sur la surface (14) du substrat (10), d'une couche d'un matériau, pouvant être sélectivement gravé par rapport au substrat, et la gravure partielle sélective de cette couche pour l'amincir dans au moins une zone correspondant à la région sélectionnée (16) du substrat.

9. Procédé de transfert selon la revendication 1, dans lequel on forme en outre, avant l'étape d), au moins une tranchée (26) de fragilisation du substrat initial (10) entourant ladite région (16) du substrat comprenant la microstructure (12).

10. Procédé de transfert selon les revendications 7 et 9 dans lequel les tranchées de fragilisation (26) et la zone de la couche de rupture (18) présentant la première épaisseur sont agencées de façon à coïncider, au moins en partie.

11. Procédé selon la revendication 11, dans lequel le matériau de liaison de la couche de liaison (30) est un matériau choisi parmi les matériaux fusibles et les matériaux présentant une force de liaison qui peut être augmentée lorsqu'ils sont soumis à un rayonnement approprié.

12. Procédé selon la revendication 1, dans lequel on forme sur le substrat final, respectivement le substrat intermédiaire des repères visibles à travers le substrat intermédiaire, respectivement le substrat final, transparent, les repères étant utilisables pour un alignement des substrats intermédiaire et final avant la mise en contact de l'étape d).

13. Procédé de transfert selon la revendication 1, **caractérisé en ce qu'**il est complété par des opérations d'interconnexion électrique de la microstructure (12) avec des composants préalablement formés sur le substrat final (32).

14. Procédé selon la revendication 1, dans lequel, lors de l'étape e), le traitement de la couche de matériau de liaison comporte l'application d'un rayonnement dans la région sélectionnée (16) du substrat comprenant la microstructure.

15. Procédé de transfert selon la revendication 14, dans lequel on utilise un substrat intermédiaire (24) transparent et on applique le rayonnement à la région sélectionnée (16) du substrat initial, comprenant la microstructure (12), à travers le substrat transparent.

16. Procédé de transfert selon la revendication 15, dans lequel on utilise un substrat final (32) transparent et applique le rayonnement à la région sélectionnée (16) du substrat initial, comprenant la microstructure (12), à travers le substrat final (32).

17. Procédé de transfert selon la revendication 1, dans lequel on utilise un matériau de liaison (30) électriquement conducteur pour former au moins une connexion électrique entre ladite région sélectionnée (16) et le substrat final (32).

## Claims

1. Process for the transfer of at least one microstructure (12) formed on a substrate (10) called the initial substrate, to another substrate (12) called the final substrate, the process comprises the following steps in sequence.
a) preparation of the initial substrate to enable reversible bonding, with an initial bond force, between the initial substrate (10) and a substrate (24) called the intermediate substrate,
b) bonding of the initial substrate (10) with the intermediate substrate (24), the microstructure facing the intermediate substrate,
c) formation of a layer (30) of bond material on at least one selected region (16) of the initial substrate including the microstructure, and/or on a reception region (16') of the final substrate, the bond material having a bond capacity that may be increased by appropriate treatment,
d) bring the said selected region (16) of the initial substrate into contact with the reception region on the final substrate,
e) treatment of the layer of bond material in an area corresponding to the selected region (16) of the initial substrate, comprising the microstructure, to increase the bond force in this area to a value exceeding the initial bond force, to fix the said selected region (16) of the initial substrate onto the reception region (16')on the final substrate (32),
f) breaking the bond between the selected region (16) of the initial substrate, including the microstructure, and the intermediate substrate(24).

2. Transfer process according to claim 1, in which the initial substrate (10) is thinned before step c).

3. Transfer process according to claim 2, in which the initial substrate (10) is thinned by chemical and/or mechanical etching.

4. Transfer process according to claim 2, in which the initial substrate (10) is thinned by cleavage along a cleavage layer (11) previously implanted in the initial substrate (10).

5. Transfer process according to claim 1, in which the preparation of the initial substrate to enable reversible bonding includes the formation of controlled roughness on the surface of substrate (10).

6. Transfer process according to claim 1, in which preparation of the initial substrate to enable reversible bonding includes the formation of at least one initiating rupture in the initial substrate.

7. Transfer process according to claim 1, in which preparation of the initial substrate to enable reversible bonding includes the formation of one layer (18) called the rupture layer on the surface (14) of substrate (10), the rupture layer having a first thickness in an area facing the selected region (16) of the initial substrate, comprising a microstructure (12), and with a second thickness exceeding the first thickness in an area located around the selected region (16).

8. Transfer process according to claim 7, in which the formation of the rupture layer (18) includes deposition on the surface (14) of the substrate (10), of a layer of a material that can be selectively etched with respect to the substrate, and partial selective etching of this layer to make it thinner in at least one area corresponding to the selected region (16) of the substrate.

9. Transfer process according to claim 1, in which at least one trench (26) weakening the initial substrate (10) surrounding the said region (16) of the substrate containing the microstructure (12), is also formed before step d).

10. Transfer process according to claims 7 and 9, in which the weakening trenches (26) and the area of the rupture layer (18) with the first thickness are laid out to coincide at least partially.

11. Process according to claim 11, in which the bond material in the bond layer (30) is chosen from meltable materials and materials with a bond force that can be increased by exposure to appropriate radiation.

12. Process according to claim 1, in which marks visible through the intermediate substrate are formed on the final substrate, and marks visible trough the final substrate are formed on the intermediate substrate, the marks being used for alignment of the intermediate and final substrates before putting into contact in step d).

13. Transfer process according to claim 1, **characterized in that** it is completed by operations to electrically connect microstructure (12) with components previously formed on the final substrate (32).

14. Process according to claim 1, in which treatment of the layer of bond material in step e) includes exposure to radiation in the selected region (16) of the substrate including the microstructure.

15. Transfer process according to claim 14, in which a transparent intermediate structure (24) is used, and radiation is applied to the selected region (16) of the initial substrate including the microstructure (12) through the transparent substrate.

16. Transfer process according to claim 15, in which a transparent final substrate (32) is used, and the selected region (16) of the initial substrate including the microstructure (12) is exposed to radiation through the final substrate (32).

17. Transfer process according to claim 1, in which an electrically conducting bond material (30) is used to form at least one electrical connection between the said selected region (16) and the final substrate (32).

## Patentansprüche

1. Verfahren zum Transfer wenigstens einer in einem Initialsubstrat genannten Substrat (10) ausgebildeten Mikrostruktur (12) auf ein Finalsubstrat genanntes Substrat (32), wobei das Verfahren die folgenden Schritte umfasst:
a) Präparieren des Initialsubstrats, um eine reversible Vereinigung, mit einer Initialbindungskraft, des Initialsubstrats (10) mit einem Zwischensubstrat genannten Substrat (24) zu ermöglichen,
b) Vereinigen des Initialsubstrats (10) mit dem Zwischensubstrat (24), wobei die Mikrostruktur dem Zwischensubstrat zugekehrt ist,
c) Bilden von wenigstens einer Bindungsmaterialschicht (30) über wenigstens einen selektierten Bereich (16) des die Mikrostruktur enthaltenden Initialsubstrats und/oder über einen Aufnahmebereich (16') des Finalsubstrats, wobei das Bindungsmaterial eine Bindungsfähigkeit hat, die durch eine geeignete Behandlung erhöht werden kann,
d) Kontakt herstellen zwischen dem genannten selektierten Bereich (16) des Initialsubstrats und dem Aufnahmebereich des Finalsubstrats,
e) Behandeln der Bindungsmaterialschicht in einer dem selektierten Bereich (16) des Initialsubstrats entsprechenden, die Mikrostruktur enthaltenden Zone, um in dieser Zone die Bindungskraft auf einen Wert zu erhöhen, der höher ist als derjenige der Initialbindungskraft, um eine Fixierung des genannten selektierten Bereichs (16) des Initialsubstrats auf dem Aufnahmebereich (16') des Finalsubstrats (32) zu realisieren,
f) Lösen des selektierten Bereichs (16) des die Mikrostruktur enthaltenden Initialsubstrats von dem Zwischensubstrat (24).

2. Transferverfahren nach Anspruch 1, bei dem man vor dem Schritt c) das Initialsubstrat (10) dünner macht.

3. Transferverfahren nach Anspruch 2, bei dem das Dünnermachen des Initialsubstrats (10) durch chemisches und/oder mechanisches Ätzen erfolgt.

4. Transferverfahren nach Anspruch 2, bei dem das Dünnermachen des Initialsubstrats (10) durch Spaltung gemäß einer vorhergehend in das Initialsubstrat (10) integrierten Spaltungsschicht (11) erfolgt.

5. Transferverfahren nach Anspruch 1, bei dem die Präparation des Initialsubstrats zur Ermöglichung einer reversiblen Vereinigung das Bilden einer kontrollierten Rauhigkeit an der Oberfläche des Substrats (10) umfasst.

6. Transferverfahren nach Anspruch 1, bei dem die Präparation des Initialsubstrats zur Ermöglichung einer reversiblen Vereinigung das Bilden wenigstens eines Anrisses bzw. einer Reißstelle in dem Initialsubstrat umfasst.

7. Transferverfahren nach Anspruch 1, bei dem die Präparation des Initialsubstrats zur Ermöglichung einer reversiblen Vereinigung das Bilden einer Reißschicht genannten Schicht (18) an der Oberfläche (14) des Substrats (10) umfasst, wobei die Reißschicht eine erste Dicke in einer Zone aufweist, die dem selektierten Bereich (16) des eine Mikrostruktur (12) enthaltenden Initialsubstrats gegenüberliegt, und in einer den selektierten Bereich (16) umgebenden Zone eine zweite Dicke aufweist, die größer ist als die erste Dicke.

8. Transferverfahren nach Anspruch 7, bei dem die Bildung der Reißschicht (18) das Abscheiden - auf der Oberfläche (14) des Substrats (10) - einer Schicht aus einem Material umfasst, das in Bezug auf das Substrat selektiv geätzt werden kann, und das selektive partielle Ätzen dieser Schicht umfasst, um sie in wenigstens einer dem selektierten Bereich (16) des Substrats entsprechenden Zone dünner zu machen.

9. Transferverfahren nach Anspruch 1, bei dem man außerdem vor dem Schritt d) wenigstens einen Rand (26) zur Schwächung des Initialsubstrats (10) realisiert, der den die Mikrostruktur (12) enthaltenden Bereich (16) des Substrats umgibt.

10. Transferverfahren nach den Ansprüchen 7 und 9, bei dem die Schwächungsgräben (26) und die die erste Dicke aufweisende Zone der Reißschicht (18) so angeordnet sind, dass sie sich wenigstens teilweise decken.

11. Verfahren nach Anspruch 1, bei dem das Bindungsmaterial der Bindungsschicht (30) ein Material ist, das ausgewählt wird unter den schmelzbaren Materialien und den Materialien, die eine Bindungskraft aufweisen, die erhöht werden kann, wenn sie einer geeigneten Strahlung ausgesetzt werden.

12. Verfahren nach Anspruch 1, bei dem man auf dem Finalsubstrat, beziehungsweise dem Zwischensubstrat, Markierungen ausbildet, die durch das Zwischensubstrat beziehungsweise das transparente Finalsubstrat hindurch sichtbar sind, wobei diese Markierungen zur Ausrichtung von Zwischen- und Finalsubstrat vor der Kontaktherstellung des Schritts d) dienen.

13. Transferverfahren nach Anspruch 1,
**dadurch gekennzeichnet,**
**dass** es vervollständigt wird durch elektrische Operationen zur Zusammenschaltung der Mikrostruktur (12) mit vorhergehend auf dem Finalsubstrat (32) ausgebildeten Komponenten.

14. Verfahren nach Anspruch 1, bei dem während des Schritts e) die Behandlung der Bindungsmaterialschicht die Anwendung einer Bestrahlung in dem selektierten Bereich (16) des die Mikrostruktur enthaltenden Substrats umfasst.

15. Transferverfahren nach Anspruch 14, bei dem man ein transparentes Zwischensubstrat (24) verwendet und die Strahlung auf den selektierten Bereich (16) des die Mikrostruktur (12) enthaltenden Initialsubstrats anwendet, durch das transparente Substrat hindurch.

16. Transferverfahren nach Anspruch 15, bei dem man ein transparentes Finalsubstrat (32) verwendet und die Strahlung auf den selektierten Bereich (16) des die Mikrostruktur (12) enthaltenden Initialsubstrats anwendet, durch das Finalsubstrat (32) hindurch.

17. Transferverfahren nach Anspruch 1, bei dem man ein elektrisch leitfähiges Bindungsmaterial (30) benutzt, um wenigstens eine elektrische Verbindung zwischen dem genannten selektierten Bereich (16) und dem Finalsubstrat (32) zu bilden.
